# EUROPÄISCHE PATENTSCHRIFT

(11) **EP 0 741 334 B1**
(45) Veröffentlichungstag und Bekanntmachung des Hinweises auf die Patenterteilung: **20.09.2000**
(21) Anmeldenummer: 96106525.7
(22) Anmeldetag: 25.04.1996
(51) Int. Cl.: G03F 7/075, G03F 7/021

(54) **Mit Wasser entschichtbares Aufzeichnungsmaterial zur Herstellung von Wasserlos-Offsetdruckplatten**
Recording material which can be decoated with water, for the production of waterless offset printing plates
Matériau d'enregistrement dépouillable avec de l'eau pour la production de plaques d'impression offset sans eau

(30) Priorität: 04.05.1995 DE 19515804
(43) Veröffentlichungstag der Anmeldung: 06.11.1996
(73) Patentinhaber: AGFA-GEVAERT N.V., 2640 Mortsel (BE)
(72) Erfinder: GRIES, Dr. Willy-Kurt,, 55252 Mainz-Kastel (DE); GRABLEY, Dr. Fritz-Feo,, 65779 Kelkheim (DE); HULTZSCH, Dr. Günter,, 65187 Wiesbaden (DE); KONRAD, Dr. Klaus Peter,, 55457 Gensingen (DE); PRZYBILLA, Dr. Klaus-Jürgen,, 60322 Frankfurt (DE); SCHLOSSER, Dr. Hans-Joachim,, 65207 Wiesbaden (DE)

(56) Entgegenhaltungen:
- EP-A- 0 349 157
- EP-A- 0 426 470
- DE-A- 2 749 639
- US-A- 4 347 303
- US-A- 4 775 607
- US-A- 4 842 988
- US-A- 5 017 457

## Beschreibung

Die vorliegende Erfindung betrifft ein Aufzeichnungsmaterial mit einem Träger, einer strahlungsempfindlichen Schicht, die ein Diazoniumsalz-Polykondensationsprodukt enthält, und einer darüber liegenden Silikonschicht. Aus dem Aufzeichnungsmaterial läßt sich eine wasserlos druckende Offsetdruckplatte herstellen.

Aufzeichnungsmaterialien der eingangs genannten Art sowie Offsetdruckplatten, die ohne Feuchtmittel auskommen (= Trockenflachdruckplatten) sind seit langem bekannt. So besteht das in der DE-A 16 71 637 beschriebene Aufzeichnungsmaterial aus einem Aluminiumträger, der eine Schicht mit einem lichtempfindlichen Diazoniumsalz und eine Silikonschicht trägt. Beim bildmäßigen Bestrahlen wird das Diazoniumsalz in den von der Strahlung getroffenen Bereichen zersetzt. Das führt dazu, daß diese Bereiche wasserlöslich werden. Sie lassen sich zusammen mit den darüber liegenden Bereichen der Silikonschicht durch leichtes Abreiben mit einer Entwicklerlösung entfernen, so daß die Aluminiumoberfläche freigelegt wird. Die Entwicklerlösung besteht beispielsweise aus Butylacetat, Propanol und Wasser. Die nichtbestrahlten Bereiche bleiben bei der Entwicklung unverändert. Diese Bereiche stoßen beim Druck die Farbe ab, während die trockene Aluminiumoberfläche die Druckfarbe annimmt.

Die wasserlos druckende Offsetdruckplatte gemäß der DE-A 15 71 890 (= US-A 3 677 178) wird aus einem Aufzeichnungsmaterial hergestellt, das aus einem Trägermaterial besteht, auf das zuerst eine Diazo- und dann die Silikonschicht aufgebracht wurde. Die Diazoschicht besteht beispielsweise aus dem Zink-Doppelsalz eines Kondensats aus Formaldehyd und 4-Diazo-diphenylamin. Beim bildmäßigen Bestrahlen werden die von der Strahlung getroffenen Bereiche der Diazoschicht gehärtet. Beim nachfolgenden Abreiben mit einem Entwickler werden die nichtbestrahlten - d. h. die nichtgehärteten - Bereiche der Diazoschicht samt den darüber liegenden Teilen der Silikonschicht entfernt, so daß an diesen Stellen das Trägermaterial wieder freigelegt ist. Als Entwickler werden allgemein wäßrige Lösungen eingesetzt, die oberflächenaktive Substanzen (Tenside) enthalten. Daneben sind auch organische Lösemittel(-gemische) verwendbar.

Das Aufzeichnungsmaterial zur Herstellung wasserlos druckender Offsetdruckplatten gemäß der DE-A 23 23 972 (= US-A 3 933 495) besteht aus einem Träger mit einer etwa 0,1 bis 3 µm dicken Schicht, die eine lichtempfindliche Substanz enthält, und einer 2 bis 5 µm dicken Schicht aus einem Ein-Komponenten-Silikonkautschuk. Die lichtempfindliche Substanz erhält man durch Umsetzen einer Diazoniumverbindung mit einem Polyhydroxybenzophenon bei einem pH-Wert von nicht mehr als 7,5. Die Diazoniumverbindung kann ein Kondensationsprodukt aus Formaldehyd und 4-Diazo-diphenylamin sein. Daneben kann die lichtempfindlichen Schicht auch noch ein Bindemittel enthalten, z. B. Epoxyharz, Phenolharz, Polyamidharz, Vinylidenchloridharz oder Celluloseester. Das Aufzeichnungsmaterial wird dann durch eine Positiv- oder Negativvorlage bildmäßig bestrahlt. Danach wird es mit einem organischen Lösemittel, wie Cyclohexanon, behandelt. Das Lösemittel entfernt die bestrahlten Bereiche der lichtempfindlichen Schicht zusammen mit den darüber liegenden Bereichen der Silikonschicht.

Gemäß der DE-A 23 50 211 (= GB 1 442 374) wird die auf die lichtempfindliche Schicht aufgebrachte, weniger als 10 µm dicke Silikonschicht mit einer Beschichtungslösung hergestellt, die ein bei Normaltemperatur aushärtendes Organopolysiloxan und einen Zwei-Komponenten-Silikonkautschuk, der durch Additionspolymerisation aushärtet, in einem bestimmten Gewichtsverhältnis enthält. Die Additionspolymerisation wird durch eine Palladium- oder Platin-Verbindung katalysiert. Die Beschichtungslösung läßt sich mehrere Stunden lang verarbeiten. Die Trocknungszeit bei etwa 100 bis 120 °C, nach der die Silikonschicht gegen Fingerabdrücke beständig ist, beträgt dennoch nur etwa 1 Minute. Aus dem so hergestellten Aufzeichnungsmaterial läßt sich durch bildmäßiges Belichten und anschließendes Entwickeln mit einem Gemisch, das reich ist an organischen Lösemitteln, beispielsweise einem Gemisch aus Xylol, Ethylenglykol-monomethyletheracetat und γ-Butyrolacton oder einem Gemisch aus Butylacetat, Propanol und Wasser, die fertige Wasserlos-Offsetdruckplatte herstellen. Wäßrige Entwickler können nicht verwendet werden.

Das Aufzeichnungsmaterial zur Herstellung von Wasserlos-Offsetdruckplatten gemäß der EP-A 0 349 157 umfaßt ebenfalls einen Träger, üblicherweise aus Aluminium, eine lichtempfindliche Schicht und eine Silikonschicht als oberste Schicht. Die Silikonschicht besteht aus Copolymeren mit Einheiten aus einem Silicon-Macromer und Einheiten aus einem fluorhaltigen Monomer. Das Silicon-Macromer ist allgemein ein Organopolysiloxan, das Acryloyl- oder Methacryloyl-Endgruppen trägt, während das fluorhaltige Monomer ein Fluoralkyl-acrylat oder -methacrylat ist. Die lichtempfindliche Schicht kann als lichtempfindliche Komponente ein Kondensationprodukt aus 4-Diazo-diphenylamin und Formaldehyd enthalten, daneben auch noch ein polymeres Bindemittel, beispielsweise ein Phenol/Formaldehyd-Harz. Zur Herstellung der Wasserlos-Offsetdruckplatten wird das bildmäßig bestrahlte Aufzeichnungsmaterial mit einem organischen Lösemittel entwickelt. Allgemein werden Gemische aus einem aliphatischen oder aromatischen Kohlenwasserstoff, wie Hexan oder Toluol, oder einem Halogenkohlenwasserstoff und einem polaren Lösemittel, wie Methanol, Ethanol oder Aceton, verwendet. Beim Entwickeln werden die vom Licht getroffenen Bereiche der Silikonschicht entfernt, während die darunter liegende, ursprünglich lichtempfindliche Schicht erhalten bleibt.

Auch in der EP-A 0 394 923 ist ein Aufzeichnungsmaterial zur Herstellung von Wasserlos-Offsetdruckplatten mit einem (Aluminium-)Trägermaterial, einer lichtempfindlichen Schicht und einer Silikonschicht beschrieben. Die lichtempfindliche Schicht enthält ein Diazoharz und ein Polymer mit Einheiten aus einem hydroxylgruppenhaltigen Ester oder Amid der Acrylsäure oder Methacrylsäure. Ein bevorzugter hydroxylgruppenhaltiger Ester der Acrylsäure ist Acrylsäure-(2-hydroxy-ethyl)-ester (= 2-Hydroxyethyl-acrylat). Als Beispiel für ein Diazoharz ist das Kondensationsprodukt aus 4-Diazo-diphenylamin und Formaldehyd genannt. Gegebenenfalls ist zwischen dem Trägermaterial und der lichtempfindlichen Schicht noch eine Primerschicht angeordnet. In der Primerschicht können auch die bereits genannten hydroxylgruppenhaltigen Polymere vorkommen. Die lichtempfindliche Schicht haftet besonders gut an dem Trägermaterial. Die Silikonkautschukschicht besteht aus linearen oder gering vernetzten Organopolysiloxanen. Das Vernetzen erfolgt durch Additions- oder Kondensationsreaktionen. Nach dem bildmäßigen Bestrahlen wird das Aufzeichnungsmaterial mit einem wäßrigen Entwickler behandelt. In den nicht vom Licht getroffenen Bereichen entfernt der Entwickler die ehemals lichtempfindliche Schicht samt den darüber liegenden Teilen der Silikonschicht.

Das Aufzeichnungsmaterial gemäß der EP-A 0 394 924 unterscheidet sich von dem eben beschriebenen dadurch, daß sich ein Teil des Diazoharzes, gemischt mit dem hydroxylgruppenhaltigen Polymer, in der Primerschicht befindet.

In dem Aufzeichnungsmaterial zur Herstellung von Wasserlos-Offsetdruckplatten gemäß der DE-A 35 45 204 enthält die lichtempfindliche Schicht ein spezielles Diazoniumsalz-Polykondensationsprodukt. Es wird durch Kondensation einer Carbonylverbindung mit einem aromatischen Diazoniumsalz und einer weiteren aromatischen Verbindung, insbesondere einem aromatischen Amin, einem Phenol, einem Phenolether, einem aromatischen Thioether, einem aromatischen Kohlenwasserstoff oder einer heteroaromatischen Verbindung, hergestellt. Die Silikonschicht besteht bevorzugt aus einem Mehrkomponenten-Silikonkautschuk. Entwickelt werden die bildmäßig bestrahlten Aufzeichnungsmaterialien mit einem organischen Lösemittel, das gegebenenfalls mit Wasser oder anderen organischen Lösemitteln gemischt ist. Bevorzugt enthält der Entwickler eine Komponente, die die Silikonschicht zu quellen vermag, und eine weitere Komponente, die die unbestrahlten Bereiche der ehemals lichtempfindlichen Schicht selektiv auflöst. Bei geeigneter Kombination von Diazoniumsalz-Polykondensationsprodukten, Bindemitteln und Entwicklern ist es auch möglich, die bestrahlten Schichtbereiche selektiv aufzulösen und so eine negativ arbeitende Wasserlos-Offsetdruckplatte zu erhalten.

Die Entwicklung der bisher handelsüblichen Wasserlos-Offsetdruckplatten erfolgt entweder durch eine Einstufen-Entschichtung mit Kohlenwasserstoff-Lösemitteln oder durch eine zweistufige Entwicklung mit Vorquellen in einem organischen Medium bei erhöhter Temperatur und anschließendem mechanischen Entfernen der Silikonschicht in den unbestrahlten Bereichen unter Zuhilfenahme von Wasser als Transportmedium. In beiden Fällen muß die Silikonschicht in den Grenzbereichen zwischen bestrahlten und unbestrahlten Bereichen vertikal durchtrennt werden. Aufgrund des Vorquellens wird dabei die Silikonschicht von der strahlungsempfindlichen Schicht abgelöst, so daß der Silikonkautschuk in den unbestrahlten Bereichen entfernt werden kann. In den bestrahlten Bereichen dagegen tritt dieser Ablösevorgang nicht auf, wodurch der Silikonkautschuk mechanisch nicht erfaßt und deshalb nicht weggeführt werden kann.

Es bestand daher die Aufgabe, ein Aufzeichnungsmaterial für die Herstellung von wasserlos druckenden Offsetdruckplatten zur Verfügung zu stellen, das sich mit reinem Wasser ohne Vorquellen der Silikonschicht und ohne Zuhilfenahme organischer Lösemittel entwickeln läßt.

Gelöst wird die Aufgabe mit einem strahlungsempfindlichen Aufzeichnungsmaterial, das einen Träger, eine strahlungsempfindliche Schicht, die ein Diazoniumsalz-Polykondensationsprodukt enthält, sowie eine auf die lichtempfindliche Schicht aufgebrachte Silikonschicht - in dieser Reihenfolge - umfaßt, dadurch gekennzeichnet, daß die strahlungsempfindliche Schicht 3 bis 50 Gew.-%, bezogen auf das Gesamtgewicht der strahlungsempfindlichen Schicht, einer Mineralsäure enthält. Dabei ist jedoch nicht erforderlich, daß die Gesamtheit der Komponenten der strahlungsempfindlichen Schicht wasserlöslich ist.

Die Mineralsäure ist bevorzugt eine relativ schwache Mineralsäure. Als "relativ schwache" Mineralsäuren werden hier solche mit einem pKₐ-Wert von mehr als 1,5 bezeichnet. Bei Mineralsäuren mit mehr als einer Dissoziationsstufe, beispielsweise Phosphorsäure, gilt dieser Wert für die jeweils erste Dissoziationsstufe. Besonders bevorzugte relativ schwache Mineralsäuren sind Phosphorsäure (pKₐ 2,16) und Borsäure (pKₐ 9,25).

Der Träger für die strahlungsempfindliche Schicht ist bevorzugt eine Metallplatte oder -folie, besonders bevorzugt aus Aluminium oder einer seiner Legierungen. Es hat sich als günstig erwiesen, den Träger vorzubehandeln. So werden die Trägermaterialien aus Aluminium üblicherweise mechanisch und/oder elektrochemisch aufgerauht und gegebenenfalls anschließend anodisch oxidiert. Danach ist noch eine chemische Vorbehandlung, beispielsweise mit Polyvinylphosphonsäure, Silikaten, Phosphaten, Hexafluorozirkonaten oder hydrolysiertem Tetraethylorthosilikat, möglich. Für das Trägermaterial sind auch Stahl und Chrom geeignet. Da - im Gegensatz zu üblichen Flachdruckplatten - keine hydrophile Trägeroberfläche erforderlich ist, können auch Kupfer, Messing oder andere oleophile Metalle verwendet werden, aber auch Kunststoffe, wie Polyester, Polycarbonat, Polyimid oder Celluloseacetat. Ebenfalls geeignet sind gummielastische Trägermaterialien mit denen auch im direkten Flachdruck gearbeitet werden kann.

Der Träger dient bei den Wasserlos-Druckplatten, die aus dem erfindungsgemäßen Aufzeichnungsmaterial hergestellt werden, als farbannehmendes Material. Die nach dem Bestrahlen und Entwickeln zurückgebliebenen Bereiche der Silikonschicht dienen als Bildhintergrund. Sie sind farbabstoßend. Zum Drucken können sowohl übliche Druckfarben auf ölbasis als auch hydrophile Druckfarben eingesetzt werden, die speziell für den wasserlosen Offsetdruck und für den umgekehrten Offsetdruck entwickelt wurden. Bevorzugt werden die beim Wasserlos-Offset üblichen oleophilen Druckfarben eingesetzt.

Die strahlungsempfindliche Schicht enthält das Kondensationsprodukt eines aromatischen Diazoniumsalzes. Solche Kondensationsprodukte sind bekannt, z. B. aus der DE-A 12 14 086 (= US-A 3 235 384). Sie können durch Kondensation einer mehrkernigen aromatischen Diazoniumverbindung (vorzugsweise eines unsubstituierten oder substituierten Diphenylamin-4-diazoniumsalzes) mit aktiven Carbonylverbindungen (vorzugsweise Formaldehyd) in stark saurem Medium (vorzugsweise konzentrierte Phosphorsäure) hergestellt werden.

Auch die in den US-A 3 867 147 und 4 021 243 genannten Diazoniumsalz-Kondensationsprodukte sind geeignet. Sie enthalten zusätzlich noch Einheiten ohne Diazoniumgruppen. Diese sind vorzugsweise von aromatischen Aminen, Phenolen, Phenolethern, aromatischen Thioethern, aromatischen Kohlenwasserstoffen, heteroaromatischen Verbindungen oder Säureamiden abgeleitet.

Die Einheiten, die die Diazoniumgruppen enthalten, werden vorzugsweise aus Verbindungen der Formel

(R¹-R²-)ₚR³-N₂X

gebildet, wobei
- x: ein Anion des Kondensationsprodukts, und
- p: eine ganze Zahl von 1 bis 3,
- R¹: ein aromatischer Rest mit mindestens einer zur Kondensation mit einer aktiven Carbonylverbindung befähigten Position,
- R²: eine Einfachbindung oder eine der Gruppen -(CH₂)_{q}-NR⁴-, -O-(CH₂)ᵣ-NR⁴-, -S-(CH₂)ᵣ-NR⁴-, -S- CH₂-CO-NR⁴-, -O-R⁵-O-, -O-, -S- oder -CO-NR⁴-,
worin
q eine ganze Zahl von 0 bis 5,
r eine ganze Zahl von 2 bis 5,
R⁴ ein Wasserstoffatom, eine (C₁-C₅)Alkylgruppe, eine (C₇-C₁₂)Aralkylgruppe oder eine (C₆-C₁₂)-Arylgruppe,
R⁵ eine (C₆-C₁₂)Arylengruppe und
- R³: ein (p+1)wertiger, unsubstituierter oder substituierter Benzolrest
bedeuten. Das Anion X des Kondensationsprodukts ist vorzugsweise Chlorid, Sulfat, Hydrogensulfat, Hydrogen-bzw. Dihydrogenphosphat, Hexafluorophosphat, Tetrafluoroborat oder ein unsubstituiertes oder substituiertes Alkan- oder Arensulfonat. Von den letztgenannten sind Methansulfonat und Mesitylensulfonat bevorzugt. Die Art des Anions ist wesentlich verantwortlich für die Löslichkeit des Diazoniumsalz-Kondensationsprodukts.

Besonders bevorzugt sind Kondensationsprodukte mit unsubstituierten oder substituierten Diphenylamin-4-diazoniumsalzen, besonders mit 3-Methoxy-diphenylamin-4-diazoniumsalzen. Besonders leicht zugänglich sind die Kondensationsprodukte der genannten Diazoniumsalze mit Formaldehyd oder mit 4,4'-Bis-methoxymethyl-diphenylether. Die Kondensation kann beispielsweise in Schwefel-, Phosphor- oder Methansulfonsäure durchgeführt werden. Phosphorsäure ist dabei besonders bevorzugt. Die Kondensationsprodukte können als Lösungen in Phosphorsäure oder in isolierter Form weiterverarbeitet werden. Die Kondensationsprodukte werden durch die Gegenwart von Mineralsäuren, wie Phosphor- oder Schwefelsäure, oder von organischen Säuren, wie p-Toluolsulfonsäure, stabilisiert. Die mit den aromatischen, zwei Methoxymethylgruppen enthaltenden Verbindungen hergestellten Kondensationsprodukte sind gegenüber den mit Carbonylverbindungen, wie Formaldehyd, hergestellten bevorzugt, da sie in der Regel zu Aufzeichnungsmaterialien mit einer höheren Strahlungsempfindlichkeit führen.

Die strahlungsempfindliche Schicht enthält allgemein 20 bis 97 Gew.-% an Diazoniumsalz-Polykondensationsprodukten. Damit sie mit Wasser entwickelbar ist, werden ferner 3 bis 50 Gew.-%, bevorzugt 5 bis 45 Gew.-%, der vorzugsweise relativ schwachen Mineralsäure hinzugefügt. Darüber hinaus werden noch bis zu 70, bevorzugt 5 bis 40 Gew.-%, besonders bevorzugt 10 bis 30 Gew.-% eines polymeren Bindemittels oder Bindemittelgemisches zugesetzt. Die Gewichtsangaben beziehen sich jeweils auf das Gesamtgewicht der strahlungsempfindlichen Schicht.

Die Bindemittel sollen polare Eigenschaften besitzen. Geeignet sind nicht-ionische, wasserlösliche Polymere und Copolymere, wie Polysaccharide, Polyethylenoxide, Polypropylenoxide, Polyoxymethylene, Polyacrylamide, Poly(N-vinyl-amide), Polyacrylate, Polymethacrylate und Polyvinylalkohole. Besonders bevorzugt sind Polymere und Copolymere mit Vinylalkohol-Einheiten. Geeignet sind auch nicht-ionische, wasserunlösliche Polymere und Copolymere, wie Epoxyharze, Acrylat- oder Methacrylatharze, Cellulosederivate. Besonders bevorzugt sind Polyvinylbutyral und davon abgeleitete Polymere. Dazu zählen insbesondere die Umsetzungsprodukte von Polyvinylbutyral mit Dicarbonsäureanhydriden, wie Maleinsäureanhydrid und Pyromellitsäureanhydrid.

Schließlich kann die strahlungsempfindliche Schicht auch noch Additive enthalten. Dies sind in erster Linie Farbstoffe, Pigmente, Haftvermittler, Tenside, Verlaufmittel oder andere Hilfsstoffe zur Verbesserung der Entschichtbarkeit und/oder der drucktechnischen Eigenschaften. Die Additive müssen mit den übrigen Bestandteilen der strahlungsempfindlichen Schicht mischbar sein, ohne daß es zu unerwünschten Reaktionen kommt. Sie dürfen zudem die bei der bildmäßigen Bestrahlung verwendete Strahlung nicht zu stark absorbieren, was die Strahlungsempfindlichkeit des Aufzeichnungsmaterials herabsetzen würde. Der Anteil der Additive beträgt nicht mehr als 20 Gew.-%, bevorzugt sogar nicht mehr als 10 Gew.-%.

Das Gewicht der strahlungsempfindlichen Schicht in dem gebrauchsfertigen Aufzeichnungsmaterial beträgt allgemein 0,001 bis 3,00 g/m², bevorzugt 0,05 bis 1,50 g/m², besonders bevorzugt 0,1 bis 1,0 g/m².

Zwischen der strahlungsempfindlichen Schicht und dem Trägermaterial kann eine der allgemein üblichen Primerschichten angeordnet sein. Sie enthält keine strahlungsempfindlichen Verbindungen.

Für die Silikonschicht eignet sich grundsätzlich jeder Silikonkautschuk, der ausreichend farbabweisend ist, um ein Drucken ohne Feuchtwasser zu erlauben. Unter der Bezeichnung "Silikonkautschuk" soll hier entsprechend der Definition von Noll, "Chemie und Technologie der Silikone", Verlag Chemie, 1968, Seite 332, ein hochmolekulares, im wesentlichen lineares Diorganopolysiloxan verstanden werden. Für die vernetzten oder vulkanisierten Produkte wird dagegen die Bezeichnung "Silikongummi" verwendet. In jedem Fall wird eine Silikonkautschuklösung auf die strahlungsempfindliche Schicht aufgebracht, getrocknet und dabei vernetzt.

Die Silikonkautschuke können Ein- oder Mehrkomponentenkautschuke sein. Beispiele dafür sind in den DE-A 23 50 211, 23 57 871 und 23 59 102 beschrieben.

Die Einkomponenten-Silikonkautschuke basieren üblicherweise auf Polydimethylsiloxanen, die an den Enden Wasserstoffatome, Acetyl-, Oxim-, Alkoxy- oder Aminogruppen oder andere funktionelle Gruppen tragen. Die Methylgruppen in der Kette können durch andere Alkylgruppen, durch Halogenalkylgruppen oder durch unsubstituierte oder substituierte Arylgruppen ersetzt sein. Die endständigen funktionellen Gruppen sind leicht hydrolysierbar und härten in Gegenwart von Feuchtigkeit in einer Zeitspanne von einigen Minuten bis wenigen Stunden aus.

Die Mehrkomponenten-Silikonkautschuke sind durch Addition oder Kondensation vernetzbar. Die additionsvernetzbaren Typen enthalten im allgemeinen zwei verschiedene Polysiloxane. Das eine Polysiloxan ist in einem Anteil von 70 bis 99 Gew.-% vorhanden und besitzt Alkylengruppen (speziell: Vinylgruppen), die an Siliciumatome der Hauptkette gebunden sind. Das andere ist in einem Anteil von 1 bis 10 Gew.-% vorhanden. Darin sind Wasserstoffatome direkt an Siliciumatome gebunden. Die Additionsreaktion erfolgt dann in Gegenwart von etwa 0,0005 bis 0,002 Gew.-% eines Platinkatalysators bei Temperaturen von mehr als 50 °C. Mehrkomponenten-Silikonkautschuke haben den Vorteil, daß sie bei höherer Temperatur (etwa 100 °C) sehr schnell vernetzen. Die Zeit, in denen sie sich verarbeiten lassen, die sogenannte "Topfzeit", ist dagegen häufig relativ kurz.

Die durch Kondensation vernetzbaren Gemische enthalten Diorganopolysiloxane mit reaktionsfähigen Endgruppen, wie Hydroxy- oder Acetoxygruppen. Diese werden mit Silanen oder Oligosiloxanen in Gegenwart von Katalysatoren vernetzt. Die Vernetzer haben einen Anteil von 2 bis 10 Gew.-%, bezogen auf das Gesamtgewicht der Silikonschicht. Die Katalysatoren haben einen Anteil von 0,01 bis 0,1 Gew.-%, wiederum bezogen auf das Gesamtgewicht der Silikonschicht. Auch diese Kombinationen reagieren relativ schnell und haben daher nur eine begrenzte Topfzeit.

Die Silikonschicht kann noch weitere Komponenten enthalten. Diese können zu einer zusätzlichen Vernetzung, einer besseren Haftung, einer mechanischen Verstärkung oder zur Einfärbung dienen. Die weiteren Komponenten haben einen Anteil von nicht mehr als 10 Gew.-%, bevorzugt nicht mehr als 5 Gew.-%, jeweils bezogen auf das Gesamtgewicht der Silikonschicht.

Ein bevorzugtes Gemisch besteht aus hydroxyterminierten Polydimethylsiloxanen, einer Silan-Vernetzungskomponente (insbesondere einem tetra- oder trifunktionellen Alkoxy-, Acetoxy-, Amido-, Amino-, Aminoxy-, Ketoxim- oder Enoxysilan), einem Vernetzungskatalysator (insbesondere einer Organozinn- oder einer Organotitan-Verbindung) und gegebenenfalls weiteren Komponenten (insbesondere Organopolysiloxanverbindungen mit Si-H-Bindungen, Platinkatalysatoren für eine zusätzliche Additionsvernetzung, Silane mit haftverbessernden Eigenschaften, Reaktionsverzögerer, Füllstoffe und/oder Farbstoffe). Die genannten Silan-Vernetzungskomponenten und die bei der Vernetzung auftretenden Reaktionen sind von J. J. Lebrun und H. Porte in "Comprehensive Polymer Science", Vol. 5 [1989] 593 - 609, beschrieben.

Die Silikonkautschuke werden nach dem Aufbringen als Schicht in bekannter Weise durch Feuchtigkeitseinwirkung oder aus sich heraus bei Raumtemperatur oder bei erhöhter Temperatur zu einem in organischen Lösemitteln im wesentlichen unlöslichen Silikongummi vernetzt. Das Gewicht der fertigen Silikonschicht beträgt im allgemeinen 1 bis 20, bevorzugt von 1 bis 5 g/m².

Die Silikonschicht kann schließlich noch mit einer transparenten Deckfolie oder einem Deckfilm überzogen werden.

Bei der Herstellung des erfindungsgemäßen Aufzeichnungsmaterials wird auf das Trägermaterial zunächst eine Lösung, die die Bestandteile der strahlungsempfindlichen Schicht enthält, aufgetragen. Auf die getrocknete Schicht wird eine Lösung mit den Bestandteilen der Silikonschicht aufgebracht, ebenfalls getrocknet und dabei vernetzt. Bedingung ist, daß diese zweite Lösung die strahlungsempfindliche Schicht möglichst unverändert läßt, d.h. sie so wenig wie möglich anlöst. Die Beschichtung erfolgt durch Gießen, Sprühen, Eintauchen, Walzenantrag oder mit Hilfe eines Flüssigkeitsfilms.

Geeignete Lösemittel für die Bestandteile der strahlungsempfindlichen Schicht sind beispielsweise Alkohole, Ketone, Ether oder Wasser. Die Bestandteile der Silikonschicht lösen sich dagegen in Kohlenwasserstoffen, wie Toluol, Xylol, insbesondere jedoch in Isoparaffinen (Siedebereich 100 bis 180 °C).

Das erfindungsgemäße Aufzeichnungsmaterial wird dann unter einer Vorlage (allgemein einer Positiv-Vorlage) mit aktinischer Strahlung, beispielsweise aus einer Metallhalogeniddampflampe, bestrahlt. Dies bewirkt eine Vernetzung in der strahlungsempfindlichen Schicht und, so wird angenommen, auch eine stärkere Verankerung der (ehemals) strahlungsempfindlichen Bereiche am Trägermaterial. In den unbestrahlten Bereichen der strahlungsempfindlichen Schicht ist die Haftung weniger stark, so daß sich die Silikonschicht und die strahlungsempfindliche Schicht beim Entwickeln mechanisch durch Reiben entfernen lassen. Der wesentliche Vorteil der erfindungsgemäßen Aufzeichnungsmaterialien liegt darin, daß zum Entschichten reines Wasser genügt. Da in Druckereien im allgemeinen nicht unter sterilen Bedingungen gearbeitet wird, ist es jedoch günstig, wenn das Wasser noch ein Biocid enthält, das das Zellwachstum verhindert. Die gebrauchsfertige Druckplatte kann noch konserviert oder eingefärbt werden.

Die nachfolgenden Beispiele sollen die Erfindung illustrieren. Gt steht darin für Gewichtsteil(e).

### Beispiel 1

Eine 0,3 mm dicke, elektrolytisch aufgerauhte und anodisch oxidierte Aluminiumplatte mit einem Oxidgewicht von 3,6 g/m² wurde mit einer 0,1 gew.-%igen wäßrigen Polyvinylphosphonsäurelösung hydrophiliert. Auf dieses Trägermaterial wurde eine Lösung aus
- 38,4 Gt: eines Diazonium-Polykondensationsprodukts aus 1 mol 3-Methoxy-diphenylamin-4-diazoniumsulfat und 1 mol 4,4'-Bis-methoxymethyl-oxy-bis-phenol (= 4,4'-Bis-methoxymethyl-diphenylether), isoliert als Methansulfonat,
- 38,4 Gt: einer 85 gew.-%igen Phosphorsäure,
- 20,0 Gt: eines Umsetzungsprodukts aus Polyvinylbutyral und Maleinsäureanhydrid (wie in der DE-A 34 04 366 beschrieben),
- 2,0 Gt: einer 40 gew.-%igen methanolischen Lösung von Trimethoxy-{3-[2-(4-vinyl-benzylamino)-ethylamino]-propyl}-silan-hydrochlorid (= N-(3-Trimethoxysilanyl-propyl)-N'-(4-vinyl-benzyl)ethylendiamin-hydrochlorid) und
- 0,4 Gt: Silikonöl in
- 2627 Gt: Ethanol und
- 3940 Gt: Diethylenglykol-monomethylether
aufgebracht und anschließend 2 min. bei 120 °C getrocknet. Das Gewicht der strahlungsempfindlichen Schicht betrug danach etwa 0,2 g/m².

Auf die strahlungsempfindliche Schicht wurde dann eine Lösung aus
- 90,5 Gt: eines hydroxyterminierten Polydimethylsiloxans (Viskosität: 5.000 mPa·s bei 20 °C),
- 9,4 Gt: Triacetoxy-vinyl-silan und
- 0,1 Gt: Dibutylzinndiacetat in
- 909 Gt: Isoparaffin (Siedebeginn 118 °C)
aufgebracht und anschließend 3 min bei 120 °C mit Umluft getrocknet. Das Gewicht der Silikonschicht betrug danach etwa 2,4 g/m².

Auf das so hergestellte Aufzeichnungsmaterial wurde eine Positiv-Vorlage aufgelegt. Anschließend wurde es durch die Vorlage hindurch 20 s lang mit einer 5 kW-Metallhalogenidlampe, die sich in einem Abstand von 110 cm befand, bestrahlt. Das auf diese Weise bildmäßig bestrahlte Aufzeichnungsmaterial wurde dann mit Wasser benetzt und durch Reiben mit einem weichen Tuch innerhalb einer Minute entwickelt ("entschichtet"). Dabei wurden die nicht von der Strahlung getroffenen Bereiche der lichtempfindlichen Schicht und der Silikonschicht entfernt, so daß das Trägermaterial in diesen Bereichen freigelegt war. Die Bildstellen wurden zur besseren Sichtbarmachung mit Wasserlos-Offsetdruckfarbe angefärbt. Die Druckplatte ergab saubere Drucke mit einer hohen Auflösung.

Das bestrahlte Aufzeichnungsmaterial ließ sich mit ebenso gutem Erfolg auch nach anderen, schon gebräuchlichen Methoden in handelsüblichen Entwicklungsgeräten entwickeln.

In einem dieser Verfahren wurde das bildmäßig bestrahlte Aufzeichnungsmaterial etwa 1 min mit einer 43 bis 45 °C warmen Lösung (Maschinenaktivator "PP-1" der Toray Ind., Inc.), die im wesentlichen aus Polypropylenglykol besteht, vorgequollen; dann mit Wasser gebürstet und anschließend mit einer wäßrigen Lösung ("PA-1" der Toray Ind., Inc.) die ein Tensid, Farbstoff und ein amphiphiles Polymer enthielt, nachbehandelt.

### Beispiele 2 bis 9

Wie im Beispiel 1 beschrieben wurden strahlungsempfindliche Aufzeichnungsmaterialien hergestellt. Die Zusammensetzungen der zur Herstellung der strahlungsempfindlichen Schichten verwendeten Beschichtungslösungen sind in der Tabelle 1 angegeben.

Anschließend wurde die Beschichtung wie im Beispiel 1 getrocknet. Nach dem Trocknen betrug das Gewicht der strahlungsempfindlichen Schicht bei den Beispielen 2 bis 4 und 6 jeweils 0,2 g/m², bei den Beispielen 5 und 7 bis 9 jeweils 0,3 g/m².

Die Silikonschicht wurde dann hergestellt durch Auftragen einer Lösung aus
- 88,5 Gt: eines hydroxyterminierten Polydimethylsiloxans (Viskosität: 5.000 mPa·s bei 20 °C),
- 9,4 Gt: Triacetoxy-vinyl-silan,
- 0,1 Gt: Dibutylzinndiacetat,
- 1,0 Gt: Polyhydrogenmethylsiloxan (Viskosität: 15 bis 30 mPa·s bei 25 °C) und
- 1,0 Gt: Platin-Katalysator (Wacker OL der Wacker GmbH) in
- 809 Gt: Isoparaffin (Siedebeginn: 118 °C).

Nach dem Beschichten wurde 3 min bei 120 °C getrocknet. Das Gewicht der Silikonschicht betrug danach jeweils 2,43 g/m². Bestrahlt und entwickelt wurde wie im Beispiel 1.

### Beispiel 10

Das im Beispiel 1 beschriebene Trägermaterial wurde mit einer Lösung aus
- 84,2 Gt: eines Diazonium-Polykondensationsprodukts aus 1 mol 3-Methoxy-diphenylamin-4-diazoniumchlorid und 1,1 mol Paraformaldehyd (50 gew.-%ig in Phosphorsäure),
- 13,8 Gt: eines Copolymers aus Acrylsäure und Hexadec-1-en (Molverhältnis 2:1), dessen Carboxygruppen zu 50 % mit Polyethylenglykol (6 bis 10 Ethylenoxid-Einheiten) verestert sind, mit einem mittleren Molekulargewicht M_{w} von 20.000,
- 0,8 Gt: Victoriablau FBR (Basic Blue 55),
- 0,8 Gt: einer 40 gew.-%igen methanolischen Lösung von Trimethoxy-{3-[2-(4-vinyl-benzylamino)-ethylamino]-propyl}-silan-hydrochlorid und
- 0,4 Gt: Silikonöl (^{(R)}Edaplan LA 411) in
- 2060 Gt: Ethanol,
- 937 Gt: Diethylenglykol-monomethylether und
- 749 Gt: Wasser
beschichtet. Nach dem Trocknen wie im Beispiel 1 betrug das Gewicht der strahlungsempfindlichen Schicht 0,3 g/m². Darauf wurde dann eine Lösung aus
- 88,5 Gt: eines hydroxyterminierten Polydimethylsiloxans (Viskosität: 80.000 mPa·s bei 20 °C),
- 9,4 Gt: Triacetoxy-vinyl-silan,
- 0,1 Gt: Dibutylzinndiacetat,
- 1,0 Gt: Polyhydrogenmethylsiloxan (Viskosität: 15 bis 30 mPa·s bei 25 °C) und
- 1,0 Gt: Platinkatalysator (Wacker OL) in
- 1329 Gt: Isoparaffin (Siedebeginn 118 °C)
aufgebracht. Nach dem Trocknen wie im Beispiel 1 betrug das Gewicht der Silikonschicht 3,11 g/m².

Nach dem bildmäßigen Bestrahlen ließ sich das Aufzeichnungsmaterial einwandfrei mit Wasser entschichten, ohne daß Rückstände in den nichtbestrahlten Bereichen zurückblieben. Die auf diese Weise hergestellten Wasserlos-Offsetdruckplatten zeigten eine gute Auflösung.

### Beispiele 11 bis 16

Das im Beispiel 1 genannte Trägermaterial wurde jeweils mit einer Lösung aus
- 38,4 Gt: eines Diazonium-Polykondensationsprodukts aus 1 mol 3-Methoxy-diphenylamin-4-diazoniumsulfat und 1 mol 4,4'-Bis-methoxymethyl-oxy-bis-phenol (= 4,4'-Bis-methoxymethyl-diphenylether), isoliert als Mesitylensulfonat,
- 20,0 Gt: eines 85 gew.-%igen Phosphorsäure,
- 20,0 Gt: eines Umsetzungsprodukts aus Polyvinylbutyral und Maleinsäureanhydrid (wie in der DE-A 34 04 366 beschrieben),
- 5,0 Gt: Victoriablau FBR (Basic Blue 55),
- 2,0 Gt: einer 40 gew.-%igen methanolischen Lösung von Trimethoxy-{3-[2-(4-vinyl-benzylamino)-ethylamino]-propyl}-silan-hydrochlorid (= N-(3-Trimethoxysilanyl-propyl)-N'-(4-vinyl-benzyl)ethylendiamin-hydrochlorid),
- 31,4 Gt: eines Additivs und
- 0,4 Gt: Silikonöl in
- 2627 Gt: Ethanol und
- 3940 Gt: Diethylenglykol-monomethylether
beschichtet und wie vorstehend beschrieben getrocknet. Das Gewicht der strahlungsempfindlichen Schicht betrug nach dem Trocknen 0,1 g/m² im Beispiel 11 und 0,2 g/m² in den Beispielen 12 bis 14 und 16. Im Beispiel 15 war die strahlungsempfindliche Schicht inhomogen, da aus der Beschichtungslösung unlösliche Bestandteil ausgefallen waren. Ein exaktes Schichtgewicht ließ sich daher in diesem Beispiel nicht bestimmen.

Anschließend wurde jeweils eine Silikonschicht aufgebracht, die mit der im Beispiel 1 genannten identisch war.

Die so hergestellten Aufzeichnungsmaterialien wurden dann bildmäßig bestrahlt und mit Wasser behandelt.

### Beispiel 11 (Vergleichsbeispiel)

Es wurde kein Additiv verwendet. Eine Entschichtung mit Wasser war nicht möglich.

### Beispiel 12

Als Additiv wurde 85 gew.-%ige Phosphorsäure eingesetzt. Die Entschichtbarkeit mit Wasser war sehr gut. Es gab keinerlei Schichtrückstände in den nichtbestrahlten Bereichen.

### Beispiel 13 (Vergleichsbeispiel)

Als Additiv wurde Polyethylenglykol-400 eingesetzt. Eine Entschichtung mit Wasser war nicht möglich.

### Beispiel 14 (Vergleichsbeispiel)

Als Additiv wurde ein Copolymer aus Acrylsäure und Hexadec-1-en (Molverhältnis 2:1), dessen Carboxygruppen zu 50 % mit Polyethylenglykol (6 bis 10 Ethylenoxid-Einheiten) verestert waren und das ein mittleres Molekulargewicht M_{W} von 20.000 hatte (^{(R)}Dapral GE 202), verwendet. Beim Entschichten mit Wasser wurde die Silikonschicht vollständig, d.h. in den bestrahlten und den nichtbestrahlten Bereichen, entfernt. Es wurde keine brauchbare Druckform erhalten.

### Beispiel 15 (Vergleichsbeispiel)

Als Additiv wurde Polyphosphorsäure verwendet. Es ließ sich kein brauchbares Aufzeichnungsmaterial herstellen.

### Beispiel 16

Als Additiv wurde Borsäure verwendet. Die Entschichtbarkeit mit Wasser war sehr gut. Es gab keinerlei Schichtrückstände in den nichtbestrahlten Bereichen.

### Beispiele 17 bis 20

Trägermaterialien wie im Beispiel 1 wurden jeweils mit einer Lösung aus
- 48,8 Gt: eines Diazonium-Polykondensationsprodukts aus 1 mol 3-Methoxy-diphenylamin-4-diazoniumchlorid und 1,1 mol Paraformaldehyd (50 gew.-%ig in Phosphorsäure),
- 10,0 Gt: eines Diazonium-Polykondensationsprodukts aus 1 mol 3-Methoxy-diphenylamin-4-diazoniumsalz und 1 mol 4,4'-Bis-methoxymethyl-diphenylether, isoliert als Mesitylensulfonat,
- 20,0 Gt: teilverseiftes Polyethylenglykol/Vinylacetat-Pfropfpolymer (Restacetalgehalt: 11,7 Gew.-%, Esterzahl: 155 mg KOH pro Gramm),
- 13,8 Gt: eines Copolymers aus Acrylsäure und Hexadec-1-en (Molverhältnis 2:1), dessen Carboxygruppen zu 50 % mit Polyethylenglykol (6 bis 10 Ethylenoxid-Einheiten) verestert sind, mit einem mittleren Molekulargewicht M_{W} von 20.000,
- 5,0 Gt: Victoriablau FBR (Basic Blue 55),
- 2,0 Gt: einer 40 gew.-%igen methanolischen Lösung von Trimethoxy-{3-[2-(4-vinyl-benzylamino)-ethylamino]-propyl}-silan-hydrochlorid und
- 0,4 Gt: Silikonöl (^{(R)}Edaplan LA 411) in
- 2145 Gt: Ethanol,
- 975 Gt: Diethylenglykol-monomethylether und
- 780 Gt: Wasser
beschichtet und wie beschrieben getrocknet. Nach dem Trocknen betrug das Gewicht der strahlungsempfindlichen Schicht jeweils 0,2 g/m².

Auf die strahlungsempfindliche Schicht wurde dann jeweils eine andere Silikonschicht aufgetragen. Die Zusammensetzungen der zum Beschichten verwendeten Silikonkautschuklösungen sind in der Tabelle 2 angegeben. Das Gewicht der getrockneten Silikonschicht betrug 3,0 g/m² im Beispiel 17, 3,3 g/m² im Beispiel 18, 3,8 g/m² im Beispiel 19 und 3,5 g/m² im Beispiel 20.

Die Entschichtbarkeit mit Wasser nach dem bildmäßigen Bestrahlen war bei den Aufzeichnungsmaterialien gemäß den Beispielen 17 bis 20 in allen Fällen sehr gut. Es gab keinerlei Schichtrückstände in den nichtbestrahlten Bereichen.

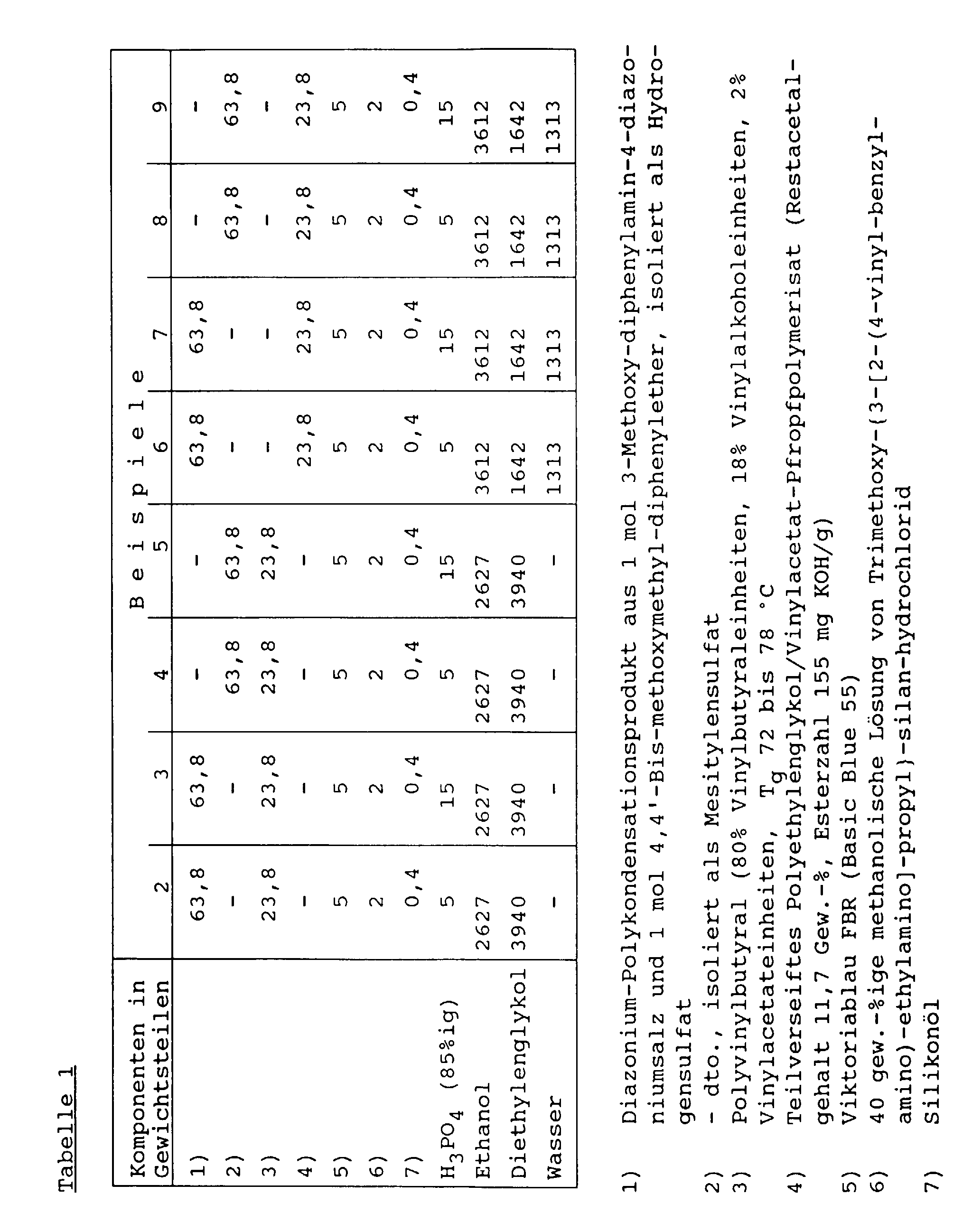

**Tabelle 2**

| | Beispiele | | | | |
|---|---|---|---|---|---|
| | 17 | 18 | 19 | 20 | 21 |
| Komponenten | Gt | Gt | Gt | Gt | Gt |
| 1) | 88,5 | 90,5 | 80,5 | 88,5 | 90,5 |
| Vinylacetoxysilan | 9,4 | 9,4 | 9,4 | 7,4 | - |
| Dibutylzinndiacetat | 0,1 | 0,1 | 0,1 | 0,1 | 0,1 |
| 2) | 1,0 | - | 1,0 | 1,0 | - |
| 3) Katalysator | 1,0 | - | 1,0 | 1,0 | - |
| 4) Farbstoffdispersion | - | - | 8,0 | - | - |
| 5) | - | - | - | 2,0 | - |
| 6) | - | - | - | - | 7,4 |
| 7) | - | - | - | - | 2,0 |
| Isoparaffin, Sdp. >118°C | 809 | 900 | 809 | 809 | 1011 |
| 1) Hydroxyterminiertes Polydimethylsiloxan (Viskosität 50.000 mPa·s bei 20 °C) 2) Polyhydrogenmethylsiloxan (Viskosität 15 bis 30 mPa·s bei 25 °C) 3) Pt-Katalysator (Wacker OL) 4) 20%ige Dispersion aus Pigment Blau 15:3 (C.I. 74160) und hydroxyterminiertes Polydimethylsiloxan (Viskosität 50.000 mPa·s bei 20 °C) im Verhältnis 1:1 in Toluol 5) Glycidopropyltrimethoxysilan 6) Vinyltris(methylethylketoxim)silan 7) 3-(2-Amino-ethylamino)-propyl-trimethoxy-silan (= H₂N(CH₂)₂NH-(CH₂)₃-Si(OCH₃)₃ | | | | | |

## Patentansprüche

1. Strahlungsempfindliches Aufzeichnungsmaterial mit einem Träger, einer strahlungsempfindlichen Schicht, die ein Diazoniumsalz-Polykondensationsprodukt enthält, sowie einer auf die lichtempfindliche Schicht aufgebrachten Silikonschicht - in dieser Reihenfolge -, dadurch gekennzeichnet, daß die strahlungsempfindliche Schicht 3 bis 50 Gew.-%, bezogen auf das Gesamtgewicht der strahlungsempfindlichen Schicht, einer Mineralsäure enthält.

2. Aufzeichnungsmaterial gemäß Anspruch 1, dadurch gekennzeichnet, daß die strahlungsempfindliche Schicht 5 bis 45 Gew.-%, bezogen auf das Gesamtgewicht der strahlungsempfindlichen Schicht, einer Mineralsäure enthält.

3. Aufzeichnungsmaterial gemäß Anspruch 1 oder 2, dadurch gekennzeichnet, daß die Mineralsäure einen pKₐ-Wert von mehr als 1,5 hat.

4. Aufzeichnungsmaterial gemäß Anspruch 3, dadurch gekennzeichnet, daß die Mineralsäure Phosphorsäure oder Borsäure ist.

5. Aufzeichnungsmaterial gemäß einem oder mehreren der Ansprüche 1 bis 4, dadurch gekennzeichnet, daß der Träger eine Metallplatte oder -folie, bevorzugt aus Aluminium oder einer seiner Legierungen, ist.

6. Aufzeichnungsmaterial gemäß einem oder mehreren der Ansprüche 1 bis 5, dadurch gekennzeichnet, daß die strahlungsempfindliche Schicht ein Kondensationsprodukt eines aromatischen Diazoniumsalzes enthält.

7. Aufzeichnungsmaterial gemäß Anspruch 6, dadurch gekennzeichnet, daß das Kondensationsprodukt eines aromatischen Diazoniumsalzes ein Kondensationsprodukt eines unsubstituierten oder substituierten Diphenylamin-4-diazoniumsalzes, bevorzugt eines 3-Methoxy-diphenylamin-4-diazoniumsalzes, mit Formaldehyd oder 4,4'-Bis-methoxymethyl-diphenylether ist.

8. Aufzeichnungsmaterial gemäß einem oder mehreren der Ansprüche 1 bis 7, dadurch gekennzeichnet, daß die strahlungsempfindliche Schicht bis zu 70 Gew.-%, bevorzugt 5 bis 40, besonders bevorzugt 10 bis 30 Gew.-%, jeweils bezogen auf das Gesamtgewicht der strahlungsempfindlichen Schicht, eines polymeren Bindemittels oder Bindemittelgemisches enthält.

9. Aufzeichnungsmaterial gemäß Anspruch 8, dadurch gekennzeichnet, daß das polymere Bindemittel polar ist.

10. Aufzeichnungsmaterial gemäß Anspruch 9, dadurch gekennzeichnet, daß das polymere Bindemittel ein nicht-ionisches, wasserlösliches Polymer oder Copolymer, bevorzugt ein Polysaccharid, Polyethylenoxid, Polypropylenoxid, Polyoxymethylen, Polyacrylamid, Poly(N-vinyl-amid), Polyacrylat, Polymethacrylat oder Polyvinylalkohol, ist.

11. Aufzeichnungsmaterial gemäß Anspruch 9, dadurch gekennzeichnet, daß das polymere Bindemittel ein nicht-ionisches, wasserunlösliches Polymer oder Copolymer, bevorzugt ein Epoxyharz, Acrylat- oder Methacrylatharz, Cellulosederivat, Polyvinylbutyral oder davon abgeleitete Polymer, speziell ein Umsetzungsprodukt von Polyvinylbutyral mit Dicarbonsäureanhydriden, ist.

12. Aufzeichnungsmaterial gemäß einem oder mehreren der Ansprüche 1 bis 11, dadurch gekennzeichnet, daß das Gewicht der strahlungsempfindlichen Schicht 0,001 bis 3,00 g/m², bevorzugt 0,05 bis 1,50 g/m², besonders bevorzugt 0,1 bis 1,0 g/m², beträgt.

13. Aufzeichnungsmaterial gemäß einem oder mehreren der Ansprüche 1 bis 12, dadurch gekennzeichnet, daß die Silikonschicht aus einem Ein- oder Mehrkomponentenkautschuk hergestellt ist.

14. Aufzeichnungsmaterial gemäß einem oder mehreren der Ansprüche 1 bis 13, dadurch gekennzeichnet, daß das Gewicht der Silikonschicht 1 bis 20, bevorzugt 1 bis 5 g/m², beträgt.

15. Aufzeichnungsmaterial gemäß einem oder mehreren der Ansprüche 1 bis 14, dadurch gekennzeichnet, daß es nach dem bildmäßigen Bestrahlen mit Wasser entschichtbar ist.

16. Verfahren zur Herstellung einer Wasserlos-Offsetdruckplatte durch bildmäßiges Bestrahlen eines Aufzeichnungsmaterials und anschließendes Entwickeln, dadurch gekennzeichnet, daß man ein Aufzeichnungsmaterial gemäß einem oder mehreren der Ansprüche 1 bis 15 verwendet und die Entwicklung mit Wasser durchführt.

## Claims

1. A radiation-sensitive recording material having a base, a radiation-sensitive layer containing a diazonium salt polycondensation product, and also a silicone layer applied on top of the photosensitive layer - in that order -, wherein the radiation-sensitive layer contains 3 to 50% by weight, relative to the total weight of the radiation-sensitive layer, of a mineral acid.

2. The recording material as claimed in claim 1, wherein the radiation-sensitive layer contains 5 to 45% by weight, relative to the total weight of the radiation-sensitive layer, of a mineral acid.

3. The recording material as claimed in claim 1 or 2, wherein the mineral acid has a pKₐ value of more than 1.5.

4. The recording material as claimed in claim 3, wherein the mineral acid is phosphoric acid or boric acid.

5. The recording material as claimed in one or more of claims 1 to 4, wherein the base is a metal plate or foil, preferably of aluminum or one of its alloys.

6. The recording material as claimed in one or more, of claims 1 to 5, wherein the radiation-sensitive layer contains a condensation product of an aromatic diazonium salt.

7. The recording material as claimed in claim 6, wherein the condensation product of an aromatic diazonium salt is a condensation product of an unsubstituted or substituted diphenylamine-4-diazonium salt, preferably of a 3-methoxydiphenylamine-4-diazonium salt, with formaldehyde or 4,4'-bismethoxymethyldiphenyl ether.

8. The recording material as claimed in one or more of claims 1 to 7, wherein the radiation-sensitive layer contains up to 70% by weight, preferably 5 to 40, particularly preferably 10 to 30% by weight, relative in each case to the total weight of the radiation-sensitive layer, of a polymeric binder or binder mixture.

9. The recording material as claimed in claim 8, wherein the polymeric binder is polar.

10. The recording material as claimed in claim 9, wherein the polymeric binder is a nonionic, watersoluble polymer or copolymer, preferably a polysaccharide, polyethylene oxide, polypropylene oxide, polyoxymethylene, polyacrylamide, poly(N-vinylamide), polyacrylate, polymethacrylate or polyvinyl alcohol.

11. The recording material as claimed in claim 9, wherein the polymeric binder is a nonionic, water-insoluble polymer or copolymer, preferably an epoxy resin, acrylate resin or methacrylate resin, cellulose derivative, polyvinylbutyral or polymer derived therefrom, especially a reaction product of polyvinyl- butyral with dicarboxylic acid anhydrides.

12. The recording material as claimed in one or more of claims 1 to 11, wherein the weight of the radiation-sensitive layer is 0.001 to 3.00 g/m², preferably 0.05 to 1.50 g/m², most preferably 0.1 to 1.0 g/m².

13. The recording material as claimed in one or more of claims 1 to 12, wherein the silicone layer is produced from a one-component or multicomponent unvulcanized rubber.

14. The recording material as claimed in one or more of claims 1 to 13, wherein the weight of the silicone layer is 1 to 20, preferably 1 to 5 g/m².

15. The recording material as claimed in one or more of claims 1 to 14, which is decoatable with water after the imagewise irradiation.

16. A method for producing a water-free offset printing plate by imagewise irradiation of a recording material and subsequent development, which comprises using a recording material as claimed in one or more of claims 1 to 15 and carrying out the development with water.

## Revendications

1. Matériau d'enregistrement sensible au rayonnement comprenant un support, une couche sensible au rayonnement qui contient un produit de polycondensation d'un sel de diazonium, ainsi qu'une couche de silicone appliquée sur la couche photosensible - dans cet ordre - caractérisé en ce que la couche sensible au rayonnement contient un acide minéral à concurrence de 3 à 50% en poids rapportés au poids total de la couche sensible au rayonnement.

2. Matériau d'enregistrement selon la revendication 1, caractérisé en ce que la couche sensible au rayonnement contient un acide minéral à concurrence de 5 à 45% en poids rapportés au poids total de la couche sensible au rayonnement.

3. Matériau d'enregistrement selon la revendication 1 ou 2, caractérisé en ce que l'acide minéral possède une valeur pKₐ supérieure à 1,5.

4. Matériau d'enregistrement selon la revendication 3, caractérisé en ce que l'acide minéral est l'acide phosphorique ou l'acide borique.

5. Matériau d'enregistrement selon une ou plusieurs des revendications 1 à 4, caractérisé en ce que le support est une plaque métallique ou une feuille métallique de préférence en aluminium ou en un de ses alliages.

6. Matériau d'enregistrement selon une ou plusieurs des revendications 1 à 5, caractérisé en ce que la couche sensible au rayonnement contient un produit de condensation d'un sel de diazonium aromatique.

7. Matériau d'enregistrement selon la revendication 6, caractérisé en ce que le produit de condensation d'un sel de diazonium aromatique est un produit de condensation d'un sel de diphénylamine-4-diazonium non substitué ou substitué, de préférence d'un sel de 3-méthoxydiphénylamine-4-diazonium avec du formaldéhyde ou de l'éther 4,4'-bisméthoxyméthyldiphénylique.

8. Matériau d'enregistrement selon une ou plusieurs des revendications 1 à 7, caractérisé en ce que la couche sensible au rayonnement contient un liant ou un mélange de liants polymères jusqu'à concurrence de 70% en poids, de préférence de 5 à 40, de manière particulièrement préférée de 10 à 30% en poids chaque fois rapportés au poids total de la couche sensible au rayonnement.

9. Matériau d'enregistrement selon la revendication 8, caractérisé en ce que le liant polymère est de type polaire.

10. Matériau d'enregistrement selon la revendication 9, caractérisé en ce que le liant polymère est un polymère ou un copolymère hydrosoluble non ionique, de préférence un polysaccharide, l'oxyde de polyéthylène, l'oxyde de polypropylène, le polyoxyméthylène, le polyacrylamide, le poly(N-vinylamide), un polyacrylate, un polyméthacrylate ou l'alcool polyvinylique.

11. Matériau d'enregistrement selon la revendication 9, caractérisé en ce que le liant polymère est un polymère ou un copolymère non ionique insoluble dans l'eau, de préférence une résine époxy, une résine d'acrylate ou de méthacrylate, un dérivé de la cellulose, le polyvinylbutyral ou un polymère qui en dérive, de manière spécifique un produit réactionnel de polyvinylbutyral avec des anhydrides dicarboxyliques.

12. Matériau d'enregistrement selon une ou plusieurs des revendications 1 à 11, caractérisé en ce que le poids de la couche sensible au rayonnement s'élève de 0,001 à 3,00 g/m², de préférence de 0,05 à 1,50 g/m², de manière particulièrement préférée de 0,1 à 1,0 g/m².

13. Matériau d'enregistrement selon une ou plusieurs des revendications 1 à 12, caractérisé en ce que la couche de silicone est préparée à partir d'un caoutchouc à un seul composant ou à plusieurs composants.

14. Matériau d'enregistrement selon une ou plusieurs des revendications 1 à 13, caractérisé en ce que le poids de la couche de silicone s'élève de 1 à 20, de préférence de 1 à 5 g/m².

15. Matériau d'enregistrement selon une ou plusieurs des revendications 1 à 14, caractérisé en ce qu'il est pelliculable avec de l'eau après l'exposition en forme d'image.

16. Procédé pour la fabrication d'un cliché d'impression offset exempt d'eau par exposition en forme d'image d'un matériau d'enregistrement et développement ultérieur, caractérisé en ce qu'on utilise un matériau d'enregistrement selon une ou plusieurs des revendications 1 à 15 et on effectue le développement avec de l'eau.
